Europäisches Patentamt

European Patent Office

Office européen des brevets

(19)

(11)  EP 1 422 315 A1

(12)  **EUROPEAN PATENT APPLICATION**

(43)  Date of publication:
26.05.2004  Bulletin 2004/22

(51)  Int Cl.⁷: **C23C 16/02**, C23C 16/40,
C23C 28/00

(21)  Application number: 03078649.5

(22)  Date of filing: 20.11.2003

(84)  Designated Contracting States:
**AT BE BG CH CY CZ DE DK EE ES FI FR GB GR
HU IE IT LI LU MC NL PT RO SE SI SK TR**
Designated Extension States:
**AL LT LV MK**

(30)  Priority: 22.11.2002  IT  MI20022482

(71)  Applicant: **Silverstar S.r.l.**
**35015 Galliera Veneta (Padova) (IT)**

(72)  Inventors:
• **Tessarolo, Alessandro**
**35015 Galliera Veneta (Padova) (IT)**
• **Tessarolo, Giovanni**
**35015 Galliera Veneta (Padova) (IT)**

(74)  Representative: **Coppo, Alessandro**
**Ing. Barzanò & Zanardo Milano S.p.A.,**
**Via Borgonuovo, 10**
**20121 Milano (IT)**

(54)  **Metallic material equipped with a protective layer realised through silicon oxides**

(57)  A material equipped with a protective layer (20) realised through silicon oxides of formula $SiO_x$, comprising a base layer (10) consisting of solid metal or of metal plating, an intermediate layer (11) made from titanium deposited on the base layer (10) and the protective layer (20) deposited on the intermediate layer (11).

**Description**

The present invention concerns a metallic material equipped with a protective layer realised through silicon oxides.

In particular, the invention concerns a metallic material equipped with a protective layer based upon silicon oxides of formula $SiO_x$ able to be obtained through a plasma enhanced deposition technique such as chemical vapour deposition.

In the field of semi-conductors, deposition techniques of various types of layer on supports have been known for some time.

The main techniques currently used for the deposition of thin films of amorphous semiconductor (for example, silicon) are:

- sputtering, in which a silicon target is bombarded by argon ions in the presence of hydrogen, so as to promote the formation of SiH groups which give rise to the growth of the film;
- Chemical Vapour Deposition (CVD), in which silane gas ($SiH_4$) is made to decompose at sufficiently high temperatures (T > 600°C);
- Plasma Enhanced Chemical Vapour Deposition (PECVD) in which the films are obtained through decomposition, through plasma, of silane gas and of other gases which are added to obtain a drugged material or an alloy.

The plasma can be obtained, for example, by using a radio-frequency capacitive system, in such a way as to obtain its confinement between two parallel electrodes.

In practice, the chemical compounds containing the atoms or molecules to be deposited are mixed in a deposition chamber to form a vapour.

The atoms or molecules thus freed are deposited on the surface to form a film or thin layer.

Amongst the various reactions that can be used we quote, amongst others, the following oxidation reactions:

$$(\text{silane, GAS}) \; SiH_4 + O_2 \rightarrow SiO_2 + 2H_2;$$

$$(\text{dichlorosilane, GAS}) \; SiCl_2H_2 + 2H_2O \rightarrow SiO_2 + 2N_2 + 2HCl; \text{HDMSO, liquid vapour.}$$

Glass, i.e. silicon oxide, is undoubtedly the material which best combines all of these characteristics since, as well as being amorphous and particularly resistant to wear and to abrasion, it does not alter the colour of the substrate material.

Since plasma is a gas formed from ion particles, i.e. ionised radicals, by operating according to the reactions shown above, for the deposition in question, the deposition of silicon oxide does not take place in stoichiometric quantities since the layer of oxide deposited tends to grow low in oxygen.

In practice an amorphous compound is obtained which can be called $SiO_x$ with x variable from about 1.5 to 2 and which has characteristics very close to those of glass, to such a point that this type of deposition creates a quartz-like layer.

Indeed, deposition techniques of various silicon-based compounds are known for the realisation of protective layers on metallic layers like brass in order to obtain protection from external agents, resistance to abrasion together with the very transparency of glass.

However, the realisation of silicon oxide depositions on materials like solid silver or silver plate as well as on gold or nickel and similar platings is not known.

The cause for such a lack of realisation is probably to be found in the substantial problems of adherence of the coating on the aforementioned materials, a thing which, however, does not happen in the case of brass.

Brass is an alloy of copper and zinc and the phase diagram between zinc and silicon has a compound in solid phase, i.e. there is a compound between them of elements in solid state.

In the case of silver, the phase diagram of these two elements (silver and silicon) does not have compounds in solid phase. Therefore, during solidification, the silver atoms tend to coordinate themselves and so do those of silicon, creating crystals of the two separate elements.

The reason for this behaviour is to be found in the greater electronic affinity existing between the atoms of the same type rather than between that existing between the atoms of different types.

The Applicant has now realised a material which, through deposition, preferably through PECVD, of a thin intermediate layer of metal on the metallic layer consisting of silver, gold, nickel, brass and the like or on the plating realised in the aforementioned materials, allows the subsequent deposition of a silicon oxide-based protective layer without there being drawbacks due to poor adherence of the latter.

One of the main purposes of the present invention, therefore, consists of providing a metallic material, in particular consisting of silver, gold, nickel, brass and the like or of the plating realised in the aforementioned materials allows the subsequent deposition of a protective layer realised through silicon oxides.

Another purpose of the present invention consists of realising coatings of pieces with complex morphology.

These and other purposes according to the present invention are accomplished by realising a material according to that which it outlined in claim 1.

Further characteristics of the present invention are object of the dependant claims.

The characteristics and advantages of the material according to the present invention shall become clearer from the following description, given as an example and not for limiting purposes, referring to the attached schematic figure illustrating a perspective view of a portion of material according to the invention.

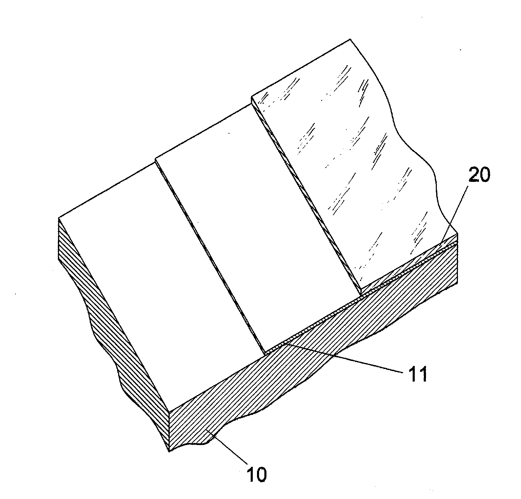

According to the figure, a preferably metallic material comprises a base layer 10 made from silver, gold, nickel, brass and the like or else through plating in the aforementioned materials.

On such a base layer 10 there is then deposition of an intermediate layer 11 of titanium particularly suitable for all types of deposition under a vacuum.

Such an intermediate layer 11 is extremely thin, in the order of a few atomic layers, so as to allow the clinging of a protective layer 20 realised through plasma enhanced chemical vapour deposition of silicon oxides, identifiable with the formula $SiO_x$ and known as quartz-like, on the material to be protected.

The material thus realised has excellent characteristics of:

- protection from external agents;
- resistance to abrasion;
- total transparency in order not to alter the colour of the substrate material.

Regarding this it should indeed be noted that, advantageously, the deposition of the layer of titanium before that of quartz-like silicon oxides $SiO_x$, does not jeopardise the outer appearance of the object since, being a few atomic layers thick, it is practically transparent to light.

## Claims

1.  Material equipped with a protective layer (20) realised through silicon oxides of formula $SiO_x$, **characterised in that** it comprises a base layer (10) consisting of solid metal or of metal plating, an intermediate layer (11) made from titanium deposited on the base layer (10) and the protective layer (20) deposited on the intermediate layer (11).

2.  Material according to claim 1, wherein said base layer (10) is made from a metal consisting of silver, gold, nickel, brass and the like or on the plating realised in the aforementioned materials.

3.  Material according to claim 1, wherein said intermediate layer (11) made from titanium has a thickness equal to a few atomic layers.

4.  Material according to claim 1, wherein said material can be obtained through a plasma enhanced chemical vapour deposition process.

# EP 1 422 315 A1

**European Patent Office**

## EUROPEAN SEARCH REPORT

Application Number

EP 03 07 8649

## DOCUMENTS CONSIDERED TO BE RELEVANT

| Category | Citation of document with indication, where appropriate, of relevant passages | Relevant to claim | CLASSIFICATION OF THE APPLICATION (Int.Cl.7) |
|---|---|---|---|
| X | US 4 713 260 A (BLACK JIMMY C ET AL) 15 December 1987 (1987-12-15) * the whole document * --- | 1-4 | C23C16/02 C23C16/40 C23C28/00 |
| X | ANONYMOUS: "Silver Metallurgy for Semiconductor Device. October 1970." IBM TECHNICAL DISCLOSURE BULLETIN, vol. 13, no. 5, 1 October 1970 (1970-10-01), pages 1118-1119, XP002273392 New York, US * the whole document * --- | 1,2 | |
| X | US 4 417 387 A (HESLOP CHRISTOPHER J) 29 November 1983 (1983-11-29) * abstract * * column 1, line 55 - line 63 * --- | 1,2 | |
| X | US 3 945 902 A (HAWRYLO FRANK ZYGMUNT ET AL) 23 March 1976 (1976-03-23) * column 1, line 64 - column 2, line 5 * --- | 1,2 | |
| X | US 4 737 252 A (HOFFMAN RICHARD A) 12 April 1988 (1988-04-12) * abstract * * column 3, line 53 - column 4, line 16; table 1 * * column 9, line 31 - line 55 * ----- | 1 | TECHNICAL FIELDS SEARCHED (Int.Cl.7) C23C |

The present search report has been drawn up for all claims

| Place of search | Date of completion of the search | Examiner |
|---|---|---|
| MUNICH | 15 March 2004 | Hintermaier, F |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

5

**ANNEX TO THE EUROPEAN SEARCH REPORT
ON EUROPEAN PATENT APPLICATION NO.**                    EP 03 07 8649

This annex lists the patent family members relating to the patent documents cited in the above-mentioned European search report.
The members are as contained in the European Patent Office EDP file on
The European Patent Office is in no way liable for these particulars which are merely given for the purpose of information.

15-03-2004

| Patent document cited in search report | | Publication date | Patent family member(s) | | Publication date |
|---|---|---|---|---|---|
| US 4713260 | A | 15-12-1987 | US | 4716071 A | 29-12-1987 |
| US 4417387 | A | 29-11-1983 | AT | 5115 T | 15-11-1983 |
| | | | DE | 3161228 D1 | 24-11-1983 |
| | | | EP | 0039174 A1 | 04-11-1981 |
| | | | JP | 56164573 A | 17-12-1981 |
| US 3945902 | A | 23-03-1976 | JP | 1025518 C | 18-12-1980 |
| | | | JP | 51035628 A | 26-03-1976 |
| | | | JP | 55015551 B | 24-04-1980 |
| | | | US | 4097636 A | 27-06-1978 |
| US 4737252 | A | 12-04-1988 | US | 4517217 A | 14-05-1985 |
| | | | CA | 1190512 A1 | 16-07-1985 |
| | | | CH | 657954 A | 15-10-1986 |
| | | | DE | 3135344 A1 | 08-07-1982 |
| | | | DK | 396281 A | 10-03-1982 |
| | | | FR | 2491956 A1 | 16-04-1982 |
| | | | FR | 2497833 A1 | 16-07-1982 |
| | | | GB | 2083842 A ,B | 31-03-1982 |
| | | | HK | 62186 A | 29-08-1986 |
| | | | IN | 157549 A1 | 19-04-1986 |
| | | | IT | 1152960 B | 14-01-1987 |
| | | | MY | 70886 A | 31-12-1986 |
| | | | NL | 8104153 A | 01-04-1982 |
| | | | US | 4495254 A | 22-01-1985 |

EPO FORM P0459

For more details about this annex : see Official Journal of the European Patent Office, No. 12/82